# EUROPEAN PATENT APPLICATION

(11) **EP 4 543 152 A1**
(43) Date of publication of application: **23.04.2025**
(21) Application number: 23214053.3
(22) Date of filing: 04.12.2023
(51) Int. Cl.: H05K 7/20, H01L 23/467

(54) **HEAT DISSIPATION EQUIPMENT CABINET**

(30) Priority: 20.10.2023 CN 202322830152 U
(71) Applicant: Schneider Electric (China) Co., Ltd., Beijing 100102 (CN)
(72) Inventor: LI, Ning, Beijing, 100102 (CN); DING, Jiaojiao, Beijing, 100102 (CN); BI, Baoyun, Beijing, 100102 (CN); LI, Huaying, Beijing, 100102 (CN); CHEN, Jiamin, Beijing, 100102 (CN); TAO, Ming, Beijing, 100102 (CN)
(74) Representative: Manitz Finsterwald Patent- und Rechtsanwaltspartnerschaft mbB

(57) **Abstract**

Embodiments of the present disclosure provides a heat dissipation equipment cabinet. The heat dissipation equipment cabinet comprises: a cabinet comprising a front wall, a rear wall and a pair of sidewalls perpendicular to the front wall, at least one of the front and rear walls comprising at least one cabinet air inlet arranged at bottom and at least one cabinet air outlet arranged at top; and a plurality of drawer assemblies spaced apart from at least one of the pair of sidewalls to form a cabinet heat dissipation channel, a drawer heat dissipation channel communicating with the cabinet heat dissipation channel being formed between every two adj acent drawer assemblies of the plurality of drawer assemblies, and wherein each of the plurality of drawer assemblies has a drawer air inlet and a drawer air outlet. This can improve the heat dissipation effect of the equipment cabinet.

## Description

### FIELD

Example embodiments of the disclosure relate generally to the field of heat dissipation cabinet, particularly to a heat dissipation equipment cabinet.

### BACKGROUND

A solid-state circuit starter, such as a solid-state circuit breaker, is a special circuit breaker that uses thyristor devices as breaking components. The solid-state circuit breaker is one of the intelligent forms of a circuit breaker, and its main structure may comprise a switch module, a main control module, a power supply module, a cooling protection module, and a signal processing module. The switch module of the solid-state circuit breaker mainly comprises power electronic devices connected in series and parallel, and opening and closing control of the current in the normal circuit are achieved by opening and closing of these devices. With the development of technology, especially in a case of high-density installation of solid-state starters, the number of electronic devices in a switchgear is increasing, and the heat generated by electronic devices in the switchgear is increasing, which leads to the current switchgear being unable to meet the heat dissipation requirements, thereby affecting the performance and reliability of the equipment.

### SUMMARY

The purpose of the disclosure is to provide a heat dissipation cabinet to at least partially solve the above problems and/or other potential problems existing in traditional heat dissipation cabinets.

In a first aspect of the present disclosure, a heat dissipation equipment cabinet is provided. The heat dissipation equipment cabinet comprises: a cabinet comprising a front wall, a rear wall and a pair of sidewalls perpendicular to the front wall, at least one of the front and rear walls comprising at least one cabinet air inlet arranged at bottom and at least one cabinet air outlet arranged at top; and a plurality of drawer assemblies, each adapted to receive a heat generating component and sequentially arranged in a predetermined position of the cabinet in a vertical direction, the plurality of drawer assemblies being spaced apart from at least one sidewall of the pair of sidewalls by a predetermined distance to form a cabinet heat dissipation channel, a drawer heat dissipation channel communicating with the cabinet heat dissipation channel being formed between every two adjacent drawer assemblies of the plurality of drawer assemblies, and wherein each of the plurality of drawer assemblies has a drawer air inlet and a drawer air outlet, and at least a portion of the plurality of drawer air outlets communicates with the cabinet heat dissipation channel by being arranged in the corresponding drawer heat dissipation channel.

In embodiments of the present disclosure, the plurality of drawer assemblies and at least one sidewall are spaced apart by a predetermined distance to form a cabinet heat dissipation channel, and the drawer heat dissipation channels are formed in communication with the cabinet heat dissipation channel between adjacent drawer assemblies, so that at least a portion of the drawer air outlets is arranged in the corresponding drawer heat dissipation channel and communicates with the cabinet heat dissipation channel. It can avoid the influence of temperature between the drawer assemblies, help to cope with the challenge of increasing the heat generation of the equipment in high-density environments, and maintain the performance and reliability of the equipment. Other benefits will be described below in conjunction with the corresponding embodiments.

In some embodiments, the drawer air outlet is arranged in a top wall of each of the plurality of drawer assemblies.

In some embodiments, an opening rate of the drawer air outlet is not less than 30%.

In some embodiments, the drawer air inlet is arranged in a lower portion of a front wall of each of the plurality of drawer assemblies.

In some embodiments, the drawer air outlet of the plurality of drawer air outlets adjacent to the cabinet air outlet is arranged in direct communication with the cabinet air outlet.

In some embodiments, the heat dissipation equipment cabinet further comprises: a plurality of seals arranged at least between front walls of every two adjacent drawer assemblies of the plurality of drawer assemblies.

In some embodiments, the heat dissipation equipment cabinet further comprises: a voltage bias bus arranged between the plurality of drawer assemblies and the rear wall in a vertical direction and connected to the heat generating components in the plurality of drawer assemblies.

In some embodiments, the heat dissipation equipment cabinet further comprises: a plurality of metal heat dissipation plates arranged at least between the voltage bias bus and a top wall of the cabinet and adjacent to the cabinet air outlet in the vertical direction.

In some embodiments, the metal heat dissipation plate has a plurality of heat dissipation holes or heat dissipation slots for increasing air circulation and heat dissipation.

In some embodiments, the heat dissipation equipment cabinet further comprises: an air flow component detachably mounted within the heat dissipation equipment cabinet and arranged adjacent to the at least one cabinet air inlet or the at least one cabinet air outlet.

It should be understood that the content described in this section is not intended to limit critical or important features of embodiments of the present disclosure, nor is it used to limit the scope of the present disclosure. Other features of the present disclosure will become easier to be understood through the following description.

### BRIEF DESCRIPTION OF THE DRAWINGS

The above and other features, advantages, and aspects of each embodiment of the present disclosure will become more apparent in conjunction with the accompanying drawings and with reference to the following detailed explanations. In the accompanying drawings, the same or similar reference signs represent the same or similar elements, where:
FIG. 1 shows a front view of a heat dissipation equipment cabinet according to some embodiments of the present disclosure; and
FIG. 2 shows a side view of a heat dissipation equipment cabinet according to some embodiments of the present disclosure.

### DETAILED DESCRIPTION

Embodiments of the present disclosure will be described in more detail below with reference to the accompanying drawings. Although certain embodiments of the disclosure are illustrated in the drawings, it should be understood that the present disclosure may be embodied in various forms and should not be construed as limited to embodiments set forth herein, but rather, these embodiments are provided for a more thorough and complete understanding of the present disclosure. It should be understood that the drawings and embodiments of the present disclosure are for illustrative purposes only and are not intended to limit the scope of the present disclosure.

In descriptions of embodiments of the present application, the term "comprise(s)" and its variants used herein indicate open inclusion, that is, "comprising but not limited to". The term "based on" should be interpreted as "based at least in part on". The terms "an embodiment" and "the embodiment" should be interpreted as "at least one exemplary embodiment". The term "some embodiments" should be interpreted as "at least some embodiments". The terms "first", "second", etc., may refer to different or the same object. Other explicit and implicit definitions may also be comprised below.

As briefly mentioned earlier, high-density installation is a trend for the use of solid-state starters. High-density installation of solid-state starters not only saves space and cost, but also has a compact structure. That is, the use of high-density installation of solid-state starters not only saves cabinet space and cost, but also has a compact structure, small footprint and weight, efficient installation, easy processing, assembly, and high reliability. These advantages also make the application of solid-state starters more and more common.

However, solid-state starters usually have a higher power density, which means that more equipment needs to be installed in a limited space. To meet this high-density installation requirement, the heat dissipation requirement becomes more complex and challenging. In traditional heat dissipation equipment cabinet used to accommodate solid-state starters, if there is no proper heat dissipation system, high-power density equipment may cause the internal temperature to rise to a dangerous level. For example, for a single starter with power of 11W/16A, if there is no proper heat dissipation and ventilation, its internal temperature may reach as high as 110 °C at an ambient temperature of 35 °C. Such a high-temperature environment poses a risk of damage to the MOSFET (metal oxide semiconductor field-effect transistor) in the device. Under the impact of short-circuit current, the junction temperature of the MOSFET will rise to 170 °C, which will greatly reduce its life and reliability. Excessive temperature will increase the thermal stress inside the device, which may cause faults and damage.

To solve or at least partially solve the above problems or other potential problems of the heat dissipation equipment cabinet of the traditional solution, embodiments of the present disclosure provide a solution of the heat dissipation equipment cabinet. The heat dissipation equipment cabinet comprises a plurality of drawers, and the drawers are respectively used to accommodate heat-generating components such as solid-state starters. According to embodiments of the present disclosure, a plurality of drawer assemblies are spaced apart from at least one sidewall by a predetermined distance to form a cabinet heat dissipation channel, and a drawer heat dissipation channels communicating with the cabinet heat dissipation channel is formed between adjacent drawer assemblies, so that at least a part of the drawer air outlets is arranged in the corresponding drawer heat dissipation channel and communicates with the cabinet heat dissipation channel. In this way, the heat-generating components in each drawer can dissipate heat independently, thereby avoiding the temperature influence between the drawer assemblies, and the temperature of equipment can be effectively controlled to prevent performance degradation and failure caused by overheating. At the same time, it can also protect equipment from temperature-related damage and provide a more stable and reliable operating environment.

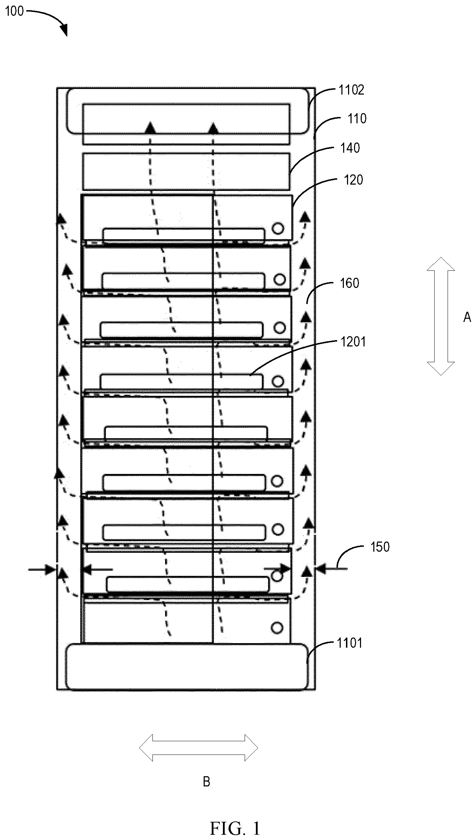

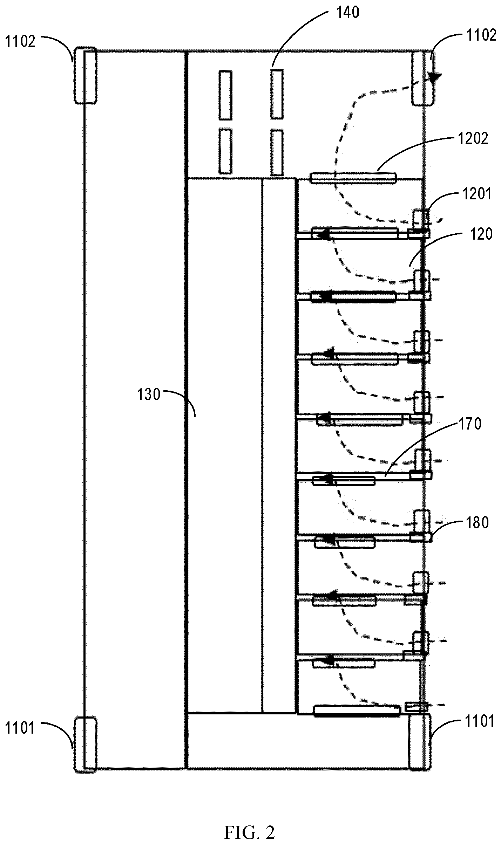

An example structure of the heat dissipation equipment cabinet 100 will be described below in conjunction with FIGS. 1 and 2. According to embodiments of the present disclosure, the heat dissipation equipment cabinet 100 is a cabinet for accommodating heat-generating components such as solid-state starters. The equipment cabinet 100 comprises a plurality of layers of drawer assemblies for respectively accommodating heat-generating components. By providing good air flow and heat dissipation, the heat dissipation equipment cabinet 100 can ensure that the equipment in the drawers remains within the appropriate temperature range during operation. This can prevent equipment performance degradation, malfunction, or even damage due to overheating.

In addition, by setting the airflow channels reasonably, with the help of air flow components such as fans, the air in the heat dissipation equipment cabinet 100 can flow along a reasonable flow path (see dashed arrows shown in the drawings) to ensure that the hot air can be effectively discharged and the cold air can flow to the key parts of the equipment. In addition, the heat dissipation equipment cabinet 100 is equipped with a temperature control system that can monitor and regulate the temperature inside the equipment cabinet. Once the temperature exceeds the set threshold, the system will automatically adjust the operating speed of the air flow components of the heat dissipation equipment cabinet 100 to ensure that the temperature remains within a safe range.

The heat dissipation equipment cabinet 100 plays a crucial role in protecting equipment, improving reliability, and extending equipment life. It not only effectively dissipates heat to prevent equipment overheating, but also has functions such as dustproof, waterproof, and shockproof, which can protect equipment from external environmental interference and damage. In the following text, the concept of the present disclosure will mainly be described using the heat dissipation equipment cabinet 100 for solid-state starters as an example. It should be understood that the situation of the solid-state starters being other components is similar, and will not be repeated separately in the following text.

As shown in FIGS. 1 and 2, the heat dissipation equipment cabinet 100 provided according to embodiments of the present disclosure generally comprises a cabinet 110 and a plurality of drawer assemblies 120. The plurality of drawer assemblies 120 are arranged at predetermined positions of the cabinet 110 for heat generating components such as solid-state starters to be arranged therein. In some embodiments, the heat generating components may comprise components such as MOSFET(s), capacitors, resistors, etc. In some embodiments, the plurality of drawer assemblies 120 are sequentially arranged at predetermined positions of the cabinet 110 in a vertical direction A. Each drawer assembly 120 may comprise one or more drawers. A plurality of drawers in the drawer assembly 120 may extend in a transverse direction B. Each drawer assembly 120 is arranged in a transverse layer of the cabinet 110. Each drawer in the drawer assembly 120 may slide in a horizontal direction (hereinafter also referred to as the insertion direction) perpendicular to the transverse direction B and the vertical direction A to achieve installation and removal of the drawer.

Further, the cabinet 110 comprises a front wall, a rear wall, and a pair of sidewalls perpendicular to the front wall. It should be understood that "front" and "rear" herein may be relative to the horizontal direction mentioned earlier. For the equipment cabinet, the front side represents a side for a user to access and store drawers, and the rear side is the opposite side to the front side.

The heat dissipation equipment cabinet 100 also comprises a voltage bias bus 130. the voltage bias bus 130 may be arranged near the rear wall relative to the plurality of drawer assemblies 120. That is, the voltage bias bus 130 is arranged between the plurality of drawer assemblies 120 and the rear wall, and is connected to the heat generating components in the plurality of drawer assemblies 120 for controlling and monitoring parameters such as voltage and current of the heat generating components.

According to embodiments of the present disclosure, the bottom of the front and rear walls of the cabinet are arranged with at least one cabinet air inlet 1101, and the top of the front and rear walls are arranged with at least one cabinet air outlet 1102. Considering the smaller density of the hot air flow, setting the cabinet air outlet at the top of the cabinet is more conducive to airflow and heat dissipation. The position of the front wall of the cabinet 110 corresponding to the drawer assemblies may be an open structure for independently heat dissipation of each layer of the drawer assembly mentioned later. In some embodiments, the widths of the cabinet air inlet 1101 and the cabinet air outlet 1102 in the transverse direction B may be greater than the width of the drawer assembly 120. Air from outside is introduced into the cabinet 110 through the cabinet air inlet 1101, and hot air from the cabinet 110 is discharged through the cabinet air outlet 1102, thereby realizing the airflow and heat dissipation of the heat dissipation equipment cabinet 100. In some embodiments, a filter and/or grid are provided at the cabinet air inlet 1101 and cabinet air outlet 1102 to prevent dust and foreign matter into the cabinet 110. The plurality of drawer assemblies 120 and at least one of the pair of sidewalls of the cabinet 110 are spaced a predetermined distance 150 to form a cabinet heat dissipation channel 160. The cabinet heat dissipation channel 160 extends in the vertical direction from the bottom of the cabinet 110 to the top of the cabinet 110. In some embodiments, a pair of sidewalls of the cabinet 110 comprises a first sidewall and a second sidewall, the plurality of drawer assemblies 120 and the first and second sidewalls are spaced apart by a predetermined distance 150, respectively. In some alternative embodiments, the plurality of drawer assemblies 120 and one sidewall are spaced apart by a predetermined distance, i.e., the plurality of drawer assemblies 120 may be spaced apart by a predetermined distance 150 from the first or second sidewall. For example, the predetermined distance 150 may be arranged not less than 35mm. For example, the predetermined distance 150 may be 44mm in some embodiments of the present disclosure. Of course, the predetermined distance 150 may also be set to other predetermined number, embodiments of the present disclosure is not particularly limited thereto. By setting the cabinet heat dissipation channel 160 reasonably, more heat can be taken away.

Continuing the above description, the plurality of drawer assemblies 120 in the vertical direction A are sequentially arranged at predetermined positions of the cabinet 110. A drawer heat dissipation channel 170 formed between every two adjacent drawer assemblies 120 of the plurality of drawer assemblies 120. The drawer heat dissipation channels 170 communicate with the cabinet heat dissipation channel 160 and are used for flow of generated hot air in the transverse direction B and collection of the hot air to the cabinet heat dissipation channel 160 through the drawer heat dissipation channels 170.

Furthermore, each drawer assembly 120 has a drawer air inlet 1201 and a drawer air outlet 1202. The drawer air inlet 1201 is used to introduce air from outside into the drawer assembly 120, the drawer air outlet 1202 is used to discharge the hot air which has absorbed the heat of the heat generating components out of the drawer assembly 120. In this manner, separately heat dissipation of each drawer assembly 120 can be effectively achieved. In some embodiments, a filter and/or grid is provided at the drawer air inlet 1201 to prevent dust and dirt from entering the drawer assembly 120.

In some embodiments, the drawer air inlet 1201 is arranged at a lower portion of the front wall of each drawer assembly 120. The drawer air outlet 1202 is arranged at a top wall of each drawer assembly 120. At least a portion of the drawer air outlets 1202 in the plurality of drawer air outlets 1202 is arranged in a corresponding drawer heat dissipation channel 170. Hot air in the plurality of drawer assemblies 120 is discharged outside the cabinet 110 through the drawer heat dissipation channels 170 communicating with the cabinet heat dissipation channel 160 to achieve effective heat dissipation of the heat dissipation equipment cabinet 100.

In some embodiments, one of the plurality of drawer air outlets 1202 adjacent to the cabinet air outlet 1102 is arranged in direct communication with the cabinet air outlet 1102. In other words, the drawer air outlet 1202 adjacent to the cabinet air outlet 1102 can allow the hot air in the corresponding drawer assembly to be directly discharged to the cabinet heat dissipation channel 160, and to be discharged from the cabinet air outlet 1102 outside the cabinet 110 for heat dissipation. In this way, the air flow rate can be increased to improve heat dissipation efficiency.

In some embodiments, the drawer air outlet 1202 comprises a plurality of vent holes arranged on the top wall of the drawer assembly 120 to allow the hot air in the drawer assembly 120 to be discharged outside. In some embodiments, the drawer air outlet 1202 may be arranged at a position near the rear end of the top wall. In this way, it is beneficial for the airflow to flow through more heat-generating components from front to back. In some alternative embodiments, the plurality of vent holes of the drawer air outlet 1202 may be uniformly distributed on the top wall of the drawer assembly 120. The opening rate and opening position of the plurality of vent holes are associated with the amount of heat in the drawer assembly 120 and the size of the drawer assembly 120. The opening rate herein is the ratio of the total area of the drawer air outlet 1202 on the top wall to the area of the opening area (the area where the air outlet is formed, rather than entire area of the non-top wall). For example, the opening rate of the drawer air outlet 1202 is not less than 30%.

In some embodiments, the heat dissipation equipment cabinet 100 further comprises an air flow component such as a fan. The air flow component is detachably mounted within the heat dissipation equipment cabinet 100 and is arranged adjacent to at least one cabinet air inlet 1101 or at least one cabinet air outlet 1102. For example, the air flow component may adopt a fan to enhance the air flow rate within the heat dissipation equipment cabinet 100 and improve heat dissipation efficiency.

In some embodiments, the heat dissipation equipment cabinet 100 further comprises a plurality of seals 180. The plurality of seals 180 are arranged at least between the front walls of every two adjacent drawer assemblies 120 of the plurality of drawer assemblies 120. The seal 180 can maintain the airtightness of the airflow channel, and can be used to prevent dust, dirt, etc. from entering the heat dissipation equipment cabinet 100 and affecting the normal operation of the equipment. At the same time, The seal 180 can prevent hot air in the drawer heat dissipation channel 170 from leaking out of the heat dissipation equipment cabinet 100 between adjacent drawer assemblies 120.

In some embodiments, the heat dissipation equipment cabinet 100 further comprises a plurality of metal heat dissipation plates 140. In some embodiments, the plurality of metal heat dissipation plates 140 are arranged at least between the voltage bias bus 130 and the top wall of the cabinet 110, and adjacent to the cabinet air outlet 1102 in the vertical direction A. The plurality of metal heat dissipation plates 140 are used to absorb and conduct heat generated by the drawer assemblies 120, so as to effectively disperse the heat from the heat dissipation equipment cabinet 100. In some embodiments, the metal heat dissipation plate 140 has a plurality of heat dissipation holes or heat dissipation slots for increasing air circulation and heat dissipation.

In some embodiments, for a single starter with power of 11W/16A, simulation analysis is performed to compare the heat dissipation effects of the heat dissipation equipment cabinet 100 in the embodiments of the present disclosure and the conventional heat dissipation equipment cabinet that is only provided with a cabinet heat dissipation channel under an ambient temperature of 35 °C. First, the simulation results of the conventional heat dissipation equipment cabinet were analyzed, since there is no drawer heat dissipation channel between the drawer assemblies in the conventional heat dissipation equipment cabinet, the heat generated by the heat generation components in the plurality of drawer assemblies affect each other, so that the temperature difference between the front and rear walls of the drawer assemblies is relatively large, resulting in poor heat dissipation of the heat dissipation equipment cabinet. For example, the temperature of the front wall of the first conventional drawer assembly adjacent to the cabinet air inlet is 95.7 ° C; and the temperature of the front wall of the second conventional drawer assembly adj acent to the first conventional drawer assembly is 100 °C, the temperature of the rear wall of the first and second conventional drawer assemblies are 38.3 ° C; the temperature of the front wall of the third conventional drawer assembly adjacent to the second conventional drawer assembly is 103.3 °C, and the temperature of the front wall of the fourth conventional drawer assembly adjacent to the third conventional drawer assembly is 103.9 °C, and the temperature of the rear wall of the third and fourth conventional drawer assemblies is 47.5 °C; the temperature of the front wall of the fifth conventional drawer assembly arranged at intervals from the fourth conventional drawer assembly is 105.1 °C, and the temperature of the rear wall of the fifth conventional drawer assembly is 56 °C, and the temperature of the front wall of the sixth conventional drawer assembly adj acent to the fifth conventional drawer assembly is 113.7 °C, and the temperature of the front wall of the seventh conventional drawer assembly adjacent to the sixth conventional drawer assembly is 117.4 °C, and the temperature of the rear wall of the sixth and seventh conventional drawer assemblies is 63.7 °C; the temperature of the front wall of the eighth conventional drawer assembly adjacent to the seventh conventional drawer assembly and cabinet air outlet is 119 °C; the temperature of the rear wall of the eighth conventional drawer assembly is 70.1 °C, and the temperature of the top wall is 85.7 °C.

Next, the simulation results of the heat dissipation equipment cabinet 100 according to embodiments of the present disclosure are analyzed, since the drawer heat dissipation channel is provided between every adjacent two of the plurality of drawer assemblies, heat respectively generated by the heat generating components within the plurality of drawer assemblies can be effectively prevented from mutual influence. Each drawer assembly can dissipate heat through the corresponding drawer heat dissipation channel, so that the temperature difference between the front and rear walls of each drawer assembly is not significant, thereby achieving a good heat dissipation effect of the heat dissipation equipment cabinet. For example, the temperature of the front wall of the first drawer assembly adjacent to the cabinet air inlet is 73.7 °C; and the temperature of the front wall of the second drawer assembly adjacent to the first drawer assembly is 85.3 °C, and the temperature of the rear wall of the first and second drawer assemblies is 42.7 °C; the temperature of the front wall of the third drawer assembly adjacent to the second drawer assembly is 77.4 °C, and the temperature of the front wall of the fourth drawer assembly adjacent to the third drawer assembly is 76.6 °C, and the temperature of the rear wall of the third and fourth drawer assemblies is 48.4 °C; the temperature of the front wall of the fifth drawer assembly spaced apart from the fourth drawer assembly is 88.2 °C, and the temperature of the rear wall of the fifth drawer assembly is 88.2 °C; and the temperature of the rear wall of the sixth drawer assembly adjacent to the fifth drawer assembly is 100.7 °C, and the temperature of the front wall of the seventh drawer assembly adjacent to the sixth drawer assembly is 111 °C, and the temperature of the rear wall of the sixth and seventh drawer assemblies is 61.3 °C; the temperature of the front wall of the eighth drawer assembly adjacent to the seventh drawer assembly and the cabinet air outlet is 99.8 °C; the temperature of the rear wall of the eighth drawer assembly is 67.8 °C, and the temperature of the top wall is 73.8 °C. Therefore, compared with the traditional heat dissipation equipment cabinet, the temperature of the top wall of the drawer assembly adjacent to the cabinet air outlet 1102 of the heat dissipation equipment cabinet 100 according to embodiments of the present disclosure can be reduced by 10 °C, so that heat dissipation can be effectively achieved to allow safe operation of the equipment in a case of the high-density installation.

The above has described the various implementations of the present disclosure. The above description is exemplary, not exhaustive, and is not limited to the various implementations disclosed. Without departing from the scope and spirit of the various implementations described, many modifications and changes will be apparent to those skilled in the field. The terminology used in this article is intended to best explain the principles, practical applications, or improvements to the technology in the market, or to enable other ordinary technicians in the field to understand the various implementations disclosed in this article.

## Claims

1. A heat dissipation equipment cabinet, **characterized by** comprising:
a cabinet (110) comprising a front wall, a rear wall and a pair of sidewalls perpendicular to the front wall, at least one of the front and rear walls comprising at least one cabinet air inlet (1101) arranged at bottom and at least one cabinet air outlet (1102) arranged at top; and
a plurality of drawer assemblies (120) each adapted to receive a heat generating component and sequentially arranged in a predetermined position of the cabinet (110) in a vertical direction (A), the plurality of drawer assemblies (120) being spaced apart from at least one sidewall of the pair of sidewalls by a predetermined distance (150) to form a cabinet heat dissipation channel (160), a drawer heat dissipation channel (170) communicating with the cabinet heat dissipation channel (160) being formed between every two adjacent drawer assemblies (120) of the plurality of drawer assemblies (120), and
wherein each of the plurality of drawer assemblies (120) has a drawer air inlet (1201) and a drawer air outlet (1202), and at least a portion of the plurality of drawer air outlets (1202) communicates with the cabinet heat dissipation channel (160) by being arranged in the corresponding drawer heat dissipation channel (170).

2. The heat dissipation equipment cabinet of claim 1, **characterized in that** the drawer air outlet (1202) is arranged in a top wall of each of the plurality of drawer assemblies (120).

3. The heat dissipation equipment cabinet of claim 2, **characterized in that** an opening rate of the drawer air outlet (1202) is not less than 30%.

4. The heat dissipation equipment cabinet of any one of claims 1-3, **characterized in that** the drawer air inlet (1201) is arranged in a lower portion of a front wall of each of the plurality of drawer assemblies (120).

5. The heat dissipation equipment cabinet of claim 2, **characterized in that** the drawer air outlet (1202) of the plurality of drawer air outlets (1202) adjacent to the cabinet air outlet (1102) is arranged in direct communication with the cabinet air outlet (1102).

6. The heat dissipation equipment cabinet of any one of claims 1-3 and 5, **characterized by** further comprising:
a plurality of seals (180) arranged at least between front walls of every two adjacent drawer assemblies (120) of the plurality of drawer assemblies (120).

7. The heat dissipation equipment cabinet of any one of claims 1-3 and 5, **characterized by** further comprising:
a voltage bias bus (130) arranged between the plurality of drawer assemblies (120) and the rear wall in a vertical direction (A) and connected to the heat generating components in the plurality of drawer assemblies (120).

8. The heat dissipation equipment cabinet of claim 7, **characterized by** further comprising:
a plurality of metal heat dissipation plates (140) arranged at least between the voltage bias bus (130) and a top wall of the cabinet (110) and adjacent to the cabinet air outlet (1102) in the vertical direction (A).

9. The heat dissipation equipment cabinet of claim 8, **characterized in that** the metal heat dissipation plate (140) has a plurality of heat dissipation holes or heat dissipation slots for increasing air circulation and heat dissipation.

10. The heat dissipation equipment cabinet of claim 8, **characterized by** further comprising:
an air flow component detachably mounted within the heat dissipation equipment cabinet and arranged adjacent to the at least one cabinet air inlet (1101) or the at least one cabinet air outlet (1102).
